# EUROPEAN PATENT APPLICATION

(11) **EP 2 256 549 A1**
(43) Date of publication of application: **01.12.2010**
(21) Application number: 10162326.2
(22) Date of filing: 07.05.2010
(51) Int. Cl.: G03F 7/00, B29C 33/00

(54) **Fabrication of Metallic Stamps for Replication Technology**

(30) Priority: 29.05.2009 US 182227 P
(71) Applicant: Obducat AB, 201 25 Malmö (SE)
(72) Inventor: Heidari, Babak, 24465, Furulund (SE)
(74) Representative: Aurell, Henrik

(57) **Abstract**

The electrodeposited Nickel stamp is replicated from a conductive master, e.g. Titanium metallic master instead of a photoresist patterned master. The conductive layer is served as a working electrode in the subsequent electrodepositing of the Nickel metal. After the electroplating, Nickel stamps are obtained by peeling the Nickel metal sheet off the conductive layer of the metallic master. Low adhesion between metallic master and Nickel stamp make it possible to delaminate the Nickel stamp without any defects.

## Description

### Field of invention:

The present invention relates to imprinting technology and particularly to the fabrication of metallic stamps for use in imprinting nano-structures.

### Background of prior art:

During the past decade rapid progress has been achieved in all aspects of nanostructure manufacturing. The requirements of the technology increase continuously and require advanced solutions from the industry. Simplified manufacturing processes, and hence cost-effective mass production of viable micro- and nano-patterned components are the actual requirements. This includes the demand of decreased processing times but on the other hand a long-life cycle and reproducibility of the manufactured products.

Nano-Imprint Lithography (NIL) meets many of the named required demands. This technique is one of the novel and advanced methods to fabricate nano scale patterns. NIL is a simple lithography process with low cost, high throughput and high resolution.

Nano-imprinting lithography is a promising technique for obtaining nano-size patterns, which is important for interdisciplinary nanoscale commercial products because of its combination of high patterning resolution in a low cost and high throughput. One of the key steps is formation of an inexpensive imprinting stamp that includes a nano-sized pattern. The manufacturing process and technologies to produce such stamp patterned in nano scale has limitations due to feature size and also it is time consuming and costly.

An inexpensive nickel stamp can be used for replication of nano structures using NIL. It is known that a nickel stamp can be replicated from a resist pattern prepared by an Electron Beam Recorder (EBR)/Electron Beam Lithography (EBL). However, this technology has several limitations. For example, the application of a seed-layer by evaporation after electron beam lithography limits the ability to manufacture smaller patterns with nano-precision. The other constraint is that the resist pattern written by EBR/EBL is not reusable, since the resist is used as a structure layer, which will be destroyed after a first nickel electroplating process. This makes the manufacturing cost of each stamp very high.

The majority of prior art on titanium dry etching has been performed on deposited thin film and implements fluorine- and/or chlorine based chemistries. Gases reported as suitable for titanium etching include: CCl₄ / O₂ with addition of fluorine containing gases; CCl₄ / CCl₂F₂ with admixtures of O₂, Cl₂ / BCl₃, Cl₂ / N₂, CF₄, CF₄O₂, SiCl₄, SiCl₄ / CF₄, and CHF₃, CF₄ / O₂, and SF₆.

Parker et al, presents an inductively coupled plasma (ICP) etching of bulk titanium for MEMS applications with a high aspect ratio. The bulk titanium etch rate and TiO₂ mask selectivity in an ICP as a function of various process parameters is presented, and optimized conditions are used to develop the titanium ICP deep etch (TIDE) process, which is capable of producing high aspect ratio structures with smooth sidewalls at etch rates in excess of 2 micrometer/min. Parker et al, J. Microchemical Society, 152 (10) c675-c683, (2005).

D'Agostino et al, describes dry etching assisted by plasma for some metals, which include Al, Ti, Tin, W and deposition of thin films from organosilicon precursors. One of the most reactive surfaces is titanium, since titanium forms a layer of stoichiometric, TiO₂. When the oxide surface layer is etched away Ti is exposed to a fluorine containing plasma, etching occurs in the presence of chlorine molecules without air contamination. d' Agostino et al, Pure and Applied Chemistry vol. 66, no. 6, Pp 1185-1194, (1994).

An aqueous metal etching composition that includes oxalic acid, peroxide, borofluoric acid and boric acid, which is particularly effective for removal of nickel, cobalt, titanium, tungsten and/or alloys thereof after silicide formation, without attacking the dielectric material and/or the semiconductor substrate, Bernard et al, WO 2006/138235 A2.

### Summary of the invention:

This invention demonstrates a method and a fabrication process to make conductive (single or multi-layer) masters (metallic master) for nickel stamp replication.

A conductive metallic master with a size of 6" is fabricated and nano structured using Electron Beam Recorder (EBR), Electron Beam Lithography (EBL) and Reactive Ion Etching (RIE). Materials for the conductive metallic master can be chosen for example from titanium, platinum, silicon carbide, gold, silver or a diamond like carbon,

As a result, the conductive master has a longer service lifetime because it can endure several electroplated Nickel stamp replication cycles without wearing out. The longer service lifetime makes the conductive master economically feasible to manufacture stamps.

This invention thus presents a method and a process of making nano-imprinting metallic stamp from a metallic master. Furthermore, the invention describes a method and a process that focuses upon high performance stamps; including sustained and reliable high performance stamp replication using end-to-end advanced etching and electroplating techniques.

Thus one aspect of the present invention is related to a process for use in imprinting lithography for fabrication of a metallic stamp (100), comprising the steps:
- providing a non-conductive substrate as a base substrate, which comprises of silicon;
- providing at conductive layer on top of the non-conductive carrier;
- providing an outer surface of the conductive layer with a nanostructure and thus obtaining a conductive or metallic master;
- replicating a metallic stamp by electroplating the said conductive or metallic master, such that the nanostructure on the outer surface of the conductive layer of the conductive or metallic master is transferred to the metallic stamp and;
- separating the metallic stamp from the conductive or metallic master and thus obtaining a metallic stamp.

The conductive layer comprises a single conductive layer, or an etch-stop layer , e.g. gold, sandwiched between a first (inner) and a second (outer) conductive layer, wherein said conductive layers comprises titanium, platinum, silicon carbide, gold, silver, a diamond-like carbon or conductive polymer, wherein said single conductive layer or said second conductive layer have a thickness corresponding to a desired height of the nanostructures to be structured on the outer layer. The thickness of the single conductive layer or said second (outer) conductive layer is essentially 300 nm.

The conductive stamp comprises a metal, and the said step of separating the metallic stamp from the conductive or metallic master comprises peeling off the metallic stamp from the conductive or metallic master.

Providing a nanostructure on said outer conductive layer of said conductive or metallic master comprises using Electron Beam Recorder or Electron Beam Lithography followed by Reactive Ion Etching, or providing a nanostructure on said outer conductive layer of said conductive or metallic master comprises using nanoimprint lithography followed by Reactive Ion Etching, wherein the nanostructure has size less than 1000 nm, or preferably of size less than 100nm, or more preferably of size less than 50nm.

The above metallic stamp may be made of nickel. Multiple said metallic stamps can be obtained by repeating the steps of:
- replicating a metallic stamp by electroplating the said conductive or metallic master, such that the nanostructure on the outer surface of the conductive or metallic master is transferred to the metallic stamp; and
- separating the metallic stamp from the conductive or metallic master, and thus obtaining plurality of metallic stamp using the same conductive or metallic master.

We have developed replication processes to produce Nickel stamps where the process uses lithography, etching and electrochemical deposition on conducting based layer. The conductive masters made of, e.g. , titanium, platinum, silicon carbide, gold, silver, diamond like carbon or conductive polymers, which can be used several times to replicate Ni stamps through electroplating. Each replicated stamp (Nickel father stamp) can in turn be used in a family plating process producing second generation Nickel stamps (Nickel mother stamp). The present method suggests cost effective patterning on a conductive layer e.g. metals and/or conductive polymer layer for nano-size conductive master fabrication and replications thereof. Experimental examples are shown to evaluate the possibilities of the process.

This process is effective for structures with Critical Dimension (CD) of size less than 1000 nm, preferably less than 100 nm and more preferably less than 50nm. This process is more suitable for high-density patterns (1.5 x CD) with aspect ratio (height/CD) of minimum 2:1.

The Electron Beam Lithography (EBL) and Reactive Ion Etching (RIE) processes are optimized and characterized on Si/Ti substrate and various resists are tested as Ti etching mask. In addition a multi-layer metal is also used to ensure the pattern depth-uniformity using layer acting as etch stop layer (4). In that case Si/Ti/Au/Ti multi-layer substrate was evaluated, where the Au layer (4) act as etch-stop layer.

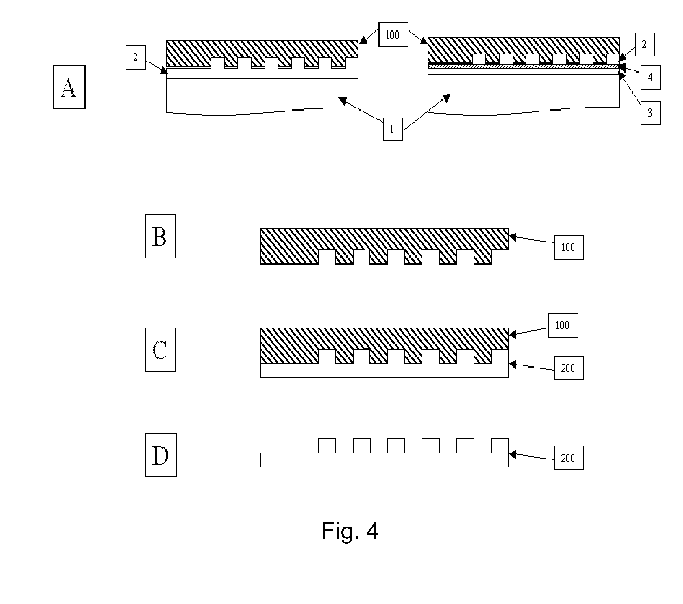

We have obtained a vertical etching profile and an etch selectivity better than 1:2 using ZEP520 resist as etch mask. The Ti metallic master provides excellent release characteristic and the transfer accuracy. A successful process to produce multiple Nickel stamp (100) from single Ti-master (Fig.4) by Ni-electroplating process has been demonstrated.

### Brief Description of the Figures:

Fig. 1: A substrate base with a conducting layer and a resist layer.
Fig. 2: A substrate base with two conducting layers, a third conducting layer which acts as an etch-stop layer and a resist layer.
Fig. 3: The process of metallic master fabrication.
Fig. 4: The master used for providing metallic stamp replication.

### Detailed description of the invention:

This invention is describing a method and a process to produce desired nano size patterns in a conductive layer. This conducting layer acts as a seed-layer in subsequent electroplating process to produce a Nickel stamp. In general the conductive layer can be conductive polymers or metals that are suitable in nickel-electroplating process.

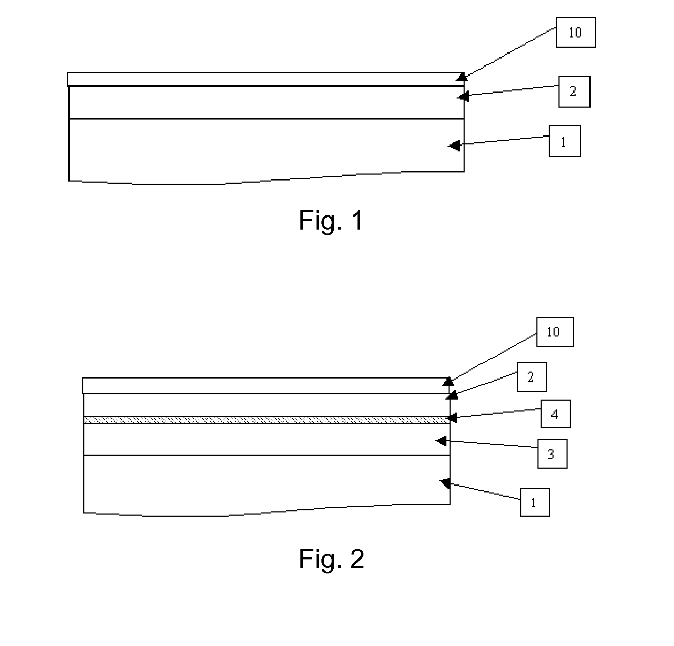

Fig. 1 shows the substrate base 1 with a conducting layer 2 and a resist layer 10, and Fig. 2 is the substrate base 1 with two conducting layers 2 and 3, a third conducting layer 4 which act as etch-stop layer and a resist layer 10.

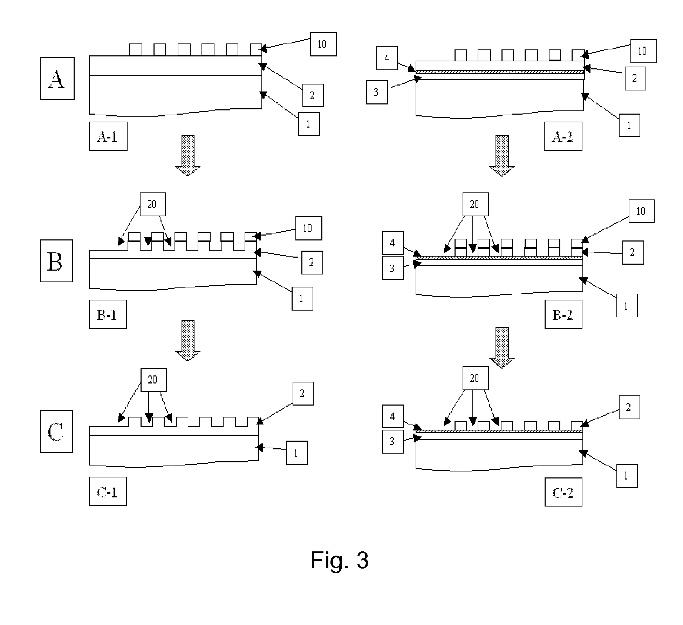

Fig. 3 shows the process of metallic master fabrication of single and multiple conductive layers.

For the single conductive layer, A-1 shows a pattered resist layer 10 on a conductive e.g. titanium layer 2, B-1 shows the etched structures 20 in the conductive layer e.g. titanium 2 using resist 10 as an etch mask, and C-1 shows the conductive master after removing off the resist and for multiple conductive layers

A-2 show pattered resist layer 10, using two conductive layers e.g. Titanium 2,3 and a third conductive layer e.g. gold 4 in-between.

Moreover, B-2 show etched structures 20 in the conductive layer e.g. titanium 2 limited to the etch-stop layer 4 using resist 10 as an etch mask, and C-2 shows the multi-layer conductive master, after removing off the resist.

Fig. 4 shows the metallic master used for providing metallic stamp replication. A is the process of electroplating a Nickel father 100 on the master 1,2 for the single layer or 1,3,4,2 for the multiple layers B is the Nickel-father-stamp 100 after separation from the master, C) is the electroplated Nickel-mother 200 on Nickel-father-stamp 100, and D is the electroplated Nickel-mother-stamp 200 after separation of the Nickel-father-stamp.

In this context, an etching model has been developed to transfer a pattern into the conductive layer using Reactive Ion Etching (RIE). Since etching is a highly complex technique it is affected by several parameters. The main focus thereby lies on the etching of different polymers and metals, which quantitative behavior is always unique for every machine. Especially the heat and UV treatment of imprint resist during imprinting process but also the aging of the polymer have a major influence on polymer etching. Metal etching on the other hand is especially affected by process control parameters of the RIE-machine, which include pressure, power, gas flow, and plate temperature. Also setting out the etching rate and roughness of etched metal surfaces by changing several of the etching parameters.

There are very critical processes that are vital to a successful manufacturing of the conductive metallic master shown in Fig. 4.

The first such process is deposition of high quality and uniform conductive layer, while second process is the patterning of the features. This can be made through different types of lithography in which the critical dimension control of the features is crucial. The third critical process is etching of the features into conductive layer after lithography step, in order to reach the target etch depth, as well as the sidewall angles of the structure, (e.g. about 85 degrees).

E-beam evaporation or sputtering technique is used to form a thin metal film 2, 3, 4, e.g. (300nm, Ti), as conducting foundation layer 2. The nano features are transferred to the foundation layer 2 in Fig. 3 by, e.g. Electron Beam Lithography (EBL), followed by a suitable Reactive Ion Etching (RIE) process. This conductive foundation layer 2 e.g. Ti, includes three-dimensional structures which are mechanically and chemically stable.

The conductive foundation layer 2 e.g. Ti, servea as a working electrode in the subsequent electrodeposition of the Ni-metal. After electroplating, nickel imprint stamps (nickel-father stamps) 100 are obtained by peeling the Ni metal films off the metallic Ti-master. Very low adhesion between Ti and Ni makes it possible to delaminate the Ni-stamp from Ti-master without any defects. Initial tests have shown that Titanium thin film 2 survived several nickel-electroplating cycles with repeatable results wich makes this metal a good candidate for this application.

Replication processes have been developed to produce nickel stamps 100,200 which involve lithography, etching and electrochemical deposition on a conducting base layer. The conductive masters shown in Fig.4 can be made of, e.g. titanium, platinum, silicon carbide, gold, silver and diamond like carbon, which can be used several times to replicate Ni stamps 100 through electroplating, and each replicated stamp (Nickel father stamp) 100 in turn can be used in a family plating process producing second generation nickel stamps (Nickel mother stamp) 200. The present method suggests cost effective patterning on a conductive layer e.g. metals and/or conductive polymer layer for nano size conductive master fabrication and replications thereof. An experimental example is shown bellow to evaluate the possibilities of the process.

### Experimental Examples:

Using the Cryofox e-beam evaporation system has done the fabrication of high quality metal thin film. Experiments show that among the many metals tested here, Titanium and Gold has been used as a good example due to excellent adhesion to Si, good etch selectivity and no chemical adhesion to Ni.

Discrete Track Recording (DTR) pattern using ZEP520 as resist, and electron beam lithography is used to pattern the ZEP520-resist, which is used as etch mask for etching the Titanium layer.

Preliminary result has shown good adhesion between Ti and ZEP520 resist 10 (Figs. 1,2). Si/Ti/Zep substrates are prepared for EBR exposure with good success. After exposure, the substrates were developed, and patterns were transferred to resist. The test patterns were DTR, LED, and other nano structures as small as 30nm.

### Example 1:

Titanium film is etched using pure SiCl₄ + Cl₂ plasma under pressure. Once the exposed Ti is etched, the remaining photoresist is stripped off with a combination of wet (remover solution) and dry etching.

Good quality thin Ti-film (200-300 nm) has been deposited on 6-inch silicon wafers. A surface roughness of 1.9 nm is measured over an area of 2.5x10 µm² by AFM.

250 nm thick Titanium layer was coated on a 6-inch silicon wafer. The wafer was cleaned with acetone, rinsed with DIW/IPA, dried, and pre-baked at 160 °C for 10 min to dehydrate the surface thereby ensuring good adhesion prior to coating with resist. A layer of ZEP520 was spin-coated onto the wafers, and post baked at 95 °C and 65°C, respectively for 1 min.

The resist layer was patterned using Electron Beam Lithography.

The residual ZEP layer was completely removed by using RIE and O₂ plasma process, (O₂=20sccm, 50Wrf, 30mTorr).

In case that the structure was smaller than 100nm, Ti film was etched using pure SiCl₄ plasma of 60sccm with 100Wrf power and 65mTorr working pressure. The etching time was adjusted to get vertical etching profile. The etch rate of 40 nm/min was achieved. Once the structure in Ti is etched, the remaining photoresist is stripped off with a combination of wet (remover solution) and dry etching (O₂-plasma). ZEP520 was used as etch mask with a selectivity of 1:1.25.

Another etch process was developed and applied to EBR exposed patterns where the structure were between 100 to 400nm. In this case RIE with SiCl₄+Cl₂ gas chemistry and different conditions (SiCl₄: 10sccm; Cl₂: 30sccm; 65Wrf; 4mTorr; T: 20C) was employed (Fig.3). An etch rate of 30nm/min was achieved.

The same process as those mentioned above has been successfully applied to EBR exposed DTR pattern by using ZEP520 as resist (Fig.3). Selectivity better than 1:2 and an etch rate of 40nm/min were achieved.

### Example 2:

Titanium film is etched using pure SiCl₄ + Cl₂ plasma under pressure. Once the exposed Ti is etched, the remaining photoresist is stripped off with a combination of wet (remover solution) and dry etching.

Good quality thin Ti-film (200-300 nm) has been deposited on 6-inch silicon wafers. A surface roughness of 1.9 nm is measured over an area of 2.5x10 µm² by AFM.

250 nm thick Titanium layer was coated on a 6-inch silicon wafer. The wafer was cleaned with acetone, rinsed with DIW/IPA, dried, and pre-baked at 160 °C for 10 min to dehydrate the surface thereby ensuring good adhesion prior to coating with resist. A layer of TU2 was spin-coated onto the wafers, and post baked at 95 °C and 65°C, respectively for 1 min.

The resist layer was patterned using Nanoimprint Lithography.

The residual TU2 layer was completely removed by using RIE and O₂ plasma process, (O₂=20sccm, 50Wrf, 30mTorr).

In case that the structure was smaller than 100nm, Ti film was etched using pure SiCl₄ plasma of 60sccm with 100Wrf power and 65mTorr working pressure. The etching time was adjusted to get vertical etching profile. The etch rate of 40 nm/min was achieved. Once the structure in Ti is etched, the remaining photoresist is stripped off with a combination of wet (remover solution) and dry etching (O₂-plasma). TU2 was used as etch mask with a selectivity of 1:1.25.

Another etch process was developed and applied to EBR exposed patterns where the structure were between 100 to 400nm. In this case RIE with SiCl₄+Cl₂ gas chemistry and different conditions (SiCl₄: 10sccm; Cl₂: 30sccm; 65Wrf; 4mTorr; T: 20C) was employed (Fig.3). An etch rate of 30nm/min was achieved.

The same process as those mentioned above has been successfully applied to EBR exposed DTR pattern by using TU2 as resist (Fig.3). Selectivity better than 1:2 and an etch rate of 40nm/min were achieved.

### Example 3:

A new experiment has been performed that is by changing the gas chemistry of Ti etching. The process carried out by using RIE with HBr +Cl₂ gas chemistry, suitable process conditions (HBr: 20sccm; Cl2: 40sccm; 80Wrf; 50mTorr), and ZEP520 as etch mask. A selectivity of 1:1.5 and an etch rate of 150nm/min are achieved. Good vertical wall profile, low roughness, and high etch rate makes this process as a good candidate to Ti etching.

### Example 4:

To improve the etch depth uniformity an etch-stop layer, 10-50 nm thin Au layer (4) has been introduced in initial layer, Si/Ti/Au/Ti (se figure 2). The preliminary result is shown a good selectivity between Au and Ti (1:20) with respect to SiCl₄ plasma RIE. Au-film can be considered as a good etch-stop layer, compared to Ti etching.

After reaching the desired etch characteristics, depth and profile, the polymer mask is removed by using both wet (Remover at 80C) and dry etching (O₂-plasma) processes followed by subsequent stamp cleaning process (Acetone + IPA). A metallic master with nano-structure is fabricated and ready for electroplating process.

After a replication of Ni film from the Ti-master (Fig. 4), the structures are mechanically stable due to the good mechanical durability of the Ti and its strong adhesion to the substrate base. The master pattern can be reused in this case.

## Claims

1. A process for use in imprinting lithography for fabrication of a metallic stamp, comprising the steps:
- providing base substrate as a carrier;
- providing a conductive layer on top of the carrier;
- providing an outer surface of the conductive layer with a nanostructure and thus obtaining a conductive or metallic master;
- replicating a metallic stamp by electroplating the said conductive or metallic master, such that the nanostructure on the outer surface of the conductive layer of the conductive or metallic master is transferred to the metallic stamp and;
- separating the metallic stamp from the conductive or metallic master and thus obtaining a metallic stamp.

2. The process according to claim 1, wherein said conductive layer comprises a single conductive layer.

3. The process according to claim 1, wherein said conductive layer comprises an etch-stop layer sandwiched between a first (inner) and a second (outer) conductive layer.

4. The process according to one of the claims 2-3, wherein said single conductive layer or said second conductive layer have a thickness corresponding to a desired height of the nanostructures to be structured on it.

5. The process according to claim 1, wherein said step of providing a base substrate as a carrier further comprises providing a non conductive substrate as said base substrate.

6. The process according to claim 1, wherein a conductive layer comprises a metal.

7. The process according to claims 1 or 6, wherein said step of separating the metallic stamp from the conductive or metallic master comprises peeling off the metallic stamp from the conductive or metallic master.

8. The process according to claim 1, wherein said step of replicating metallic stamp using the conductive or metallic master comprises electroplating process.

9. The process according to claim 1, wherein the step of providing a nanostructure on said outer conductive layer of said conductive or metallic master comprises using Electron Beam Recorder or Electron Beam Lithography followed by Reactive Ion Etching.

10. The process according to claim 1, wherein the step of providing a nanostructure on said outer conductive layer of said conductive or metallic master comprises using nanoimprint lithography.

11. The process according to claims 1 and 10, wherein the step of providing a nanostructure on said outer conductive layer of said conductive or metallic master comprises using nanoimprint lithography followed by Reactive Ion Etching.

12. The process according to claim 1, wherein said conductive layer may comprises, but not limited to, titanium, platinum, silicon carbide, gold, silver or a diamond-like carbon.

13. The process according to claim 1, wherein said conductive layer comprises conductive polymers.

14. The process according to claim 3, wherein the first and second conductive layers comprise titanium and the etch-stop layer comprises gold.

15. The process according to claim 1, wherein said carrier comprises silicon.

16. The process according to claim 1, wherein the nanostructure has a size less than 1000 nm, more preferably less than 100 nm and most preferably less than 50 nm.

17. The process according to claim 1, wherein said metallic stamp is made of nickel.

18. The process according to claim 1, further comprising the step of obtaining multiple said metallic stamps by repeating the steps:
- replicating a metallic stamp by electroplating the said conductive or metallic master, such that the nanostructure on the outer surface of the conductive layer of the conductive or metallic master is transferred to the metallic stamp; and
- separating the metallic stamp from the conductive or metallic master and thus obtaining plurality of metallic stamp using the same conductive or metallic master.
